# EUROPEAN PATENT APPLICATION

(11) **EP 4 521 871 A1**
(43) Date of publication of application: **12.03.2025**
(21) Application number: 24150292.1
(22) Date of filing: 04.01.2024
(51) Int. Cl.: H05K 7/20

(54) **METHOD OF PERFORMING OVER-TEMPERATURE CONTROL IN A NETWORK SYSTEM**

(30) Priority: 08.09.2023 US 202363537206 P; 08.12.2023 TW 112147889
(71) Applicant: Moxa Inc., New Taipei City 242 (TW)
(72) Inventor: Kao, Chang-Yang, 242 New Taipei City (TW); Liang, Yu-Ping, 242 New Taipei City (TW); Chen, Fei-Hung, 242 New Taipei City (TW)
(74) Representative: Straus, Alexander

(57) **Abstract**

The present invention provides a method of predicting over-temperature events, providing over-temperature countermeasures and system recovery in a network system. During the period when the network system operates in a normal mode, the temperature of the network system is monitored on a real-time basis for providing two-stage automatic over-temperature notification mechanism. When an over-temperature error is detected, the network system switches to operate in a light-load mode for reducing waste heat. When it is determined that the over-temperature error might have been solved based on the temperature variation of the network system or the operation time in the power-saving mode, or when receiving a restart signal issued from a remote server, the network system switches back to operate in the normal mode, thereby providing an automatic system recovery mechanism.

## Description

### Field of the Invention

The present invention is related to a method of performing over-temperature control in a network system by predicting over-temperature events, providing over-temperature countermeasures and providing system recovery in a network system.

### Background of the Invention

A data center is a facility that centralizes an organization's IT operations and equipment for the purposes of storing, processing and disseminating data and applications. Housing an organization's most critical and proprietary assets, data centers are vital to the continuity of daily operations and typically include servers, storage systems, network equipment (such as network switches, routers and firewalls), application controllers, and racks/cables for organizing and connecting each device.

In the past, data center infrastructures were highly controlled, physical environments, but the public cloud has since changed that model. Most modern data center infrastructures have evolved from on-premises physical servers to virtualized infrastructure that supports applications and workloads across multi-cloud environments. Application workloads are moving across multiple data centers and private, public and hybrid clouds. A network switch is a bridge designed to build a network connection in a data center or between different data centers by using packet switching to receive and forward data to the destination device.

Since the workload of data centers today relies on high-performance, scalable and reliable network switching operations, many network switches are mounted at the top of the rack or cabinet with servers beneath them. The network switches emanate a considerable amount heat especially when running to their full capacity. Any over-heated component within the network switches is detrimental because it can cause the entire network system to shut down, leading to substantial downtime and halting operations. Therefore, there are a few cooling strategies for network switches: passive cooling or active cooling. A passive cooling system achieves high levels of natural convection and heat dissipation by utilizing a heat spreader or a heat sink. Active cooling, on the other hand, refers to cooling technologies that rely on an external device to enhance heat transfer. For example, a fanless network switch without any built-in fans adopts a passive cooling system for ensuring noiseless operation without disrupting its working environment. A network switch with built-in fans adopts an active cooling system in which the built-in fans bring force air when natural convection is insufficient to remove heat.

Regarding high-temperature specifications of information technology (IT) products, field-related over-temperature problems can normally be solve using cooling fans. On the other hands, industrial control system (ICS) is a collective term used to describe different types of control systems and associated devices, systems, networks, and controls used to operate and/or automate industrial processes, wherein operational technology (OT) refers to the hardware and software executed in an isolated and independent network for changing, monitoring or controlling physical devices, processes, and events in ICS. Even with over-temperature protection scheme, certain harsh environments of OT applications may fail to provide sufficient user control and guarantee safe operations required by OT product specifications. Operating an OT product in an uncontrolled environment may cause device damages and communication interruptions in the actual link, thereby resulting in failed system recovery.

Regardless of the cooling strategies, prior art network switches for OT applications do not provide any over-temperature prediction, over-temperature countermeasures and system recovery mechanisms which allow the administrators to monitor and control the operational status of the network switches on a real-time basis.

### Summary of the Invention

The present invention aims at providing a method of performing over-temperature control in a network system by predicting over-temperature events, providing over-temperature countermeasures and providing system recovery in a network system.

This is achieved by a method of performing over-temperature control in a network system according to claim 1. The dependent claims pertain to corresponding further developments and improvements.

As will be seen more clearly from the detailed description following below, the claimed method of performing over-temperature control in a network system, includes operating the network system in a normal mode and monitoring a temperature of the network system during operation; notifying a remote server of a possible imminent over-temperature error when determining that the temperature of the network system is greater than an alert temperature; and notifying the remote server of an occurring over-temperature error and operating the network system in a light-load mode when determining that the temperature of the network system is greater than a maximum operating temperature longer than a first period. The network system generates less heat when operating in the light-load mode than in the normal mode. The network system is unable to function normally when the temperature of the network system is greater than the maximum operating temperature. The alert temperature is not higher than the maximum operating temperature.

### Brief Description of the Drawings

In the following, the invention is further illustrated by way of example, taking reference to the accompanying drawings.
FIG. 1 is a flowchart illustrating a method of predicting over-temperature events, providing over-temperature countermeasures and providing system recovery in a network system according to an embodiment of the present invention.
FIG. 2 is a flowchart illustrating a method of predicting over-temperature events, providing over-temperature countermeasures and providing system recovery in a network system according to another embodiment of the present invention.

### Detailed Description

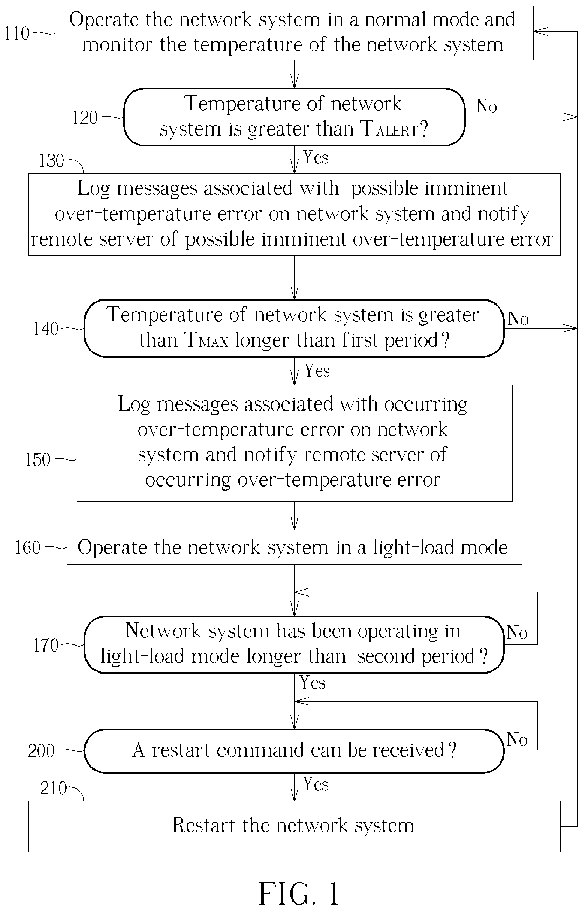

FIG. 1 is a flowchart illustrating a method of predicting over-temperature events, providing over-temperature countermeasures and providing system recovery in a network system according to an embodiment of the present invention. The flowchart in FIG. 1 includes the following steps:

| | |
|---|---|
| Step 110 : | operate the network system in a normal mode and monitor the temperature of the network system during operation. |
| Step 120: | determine whether the temperature of the network system is greater than an alert temperature T_{ALERT}; if yes, execute step 130; if no, execute step 110. |
| Step 130 : | log messages associated with a possible imminent over-temperature error on the network system and notify a remote server of the possible imminent over-temperature error; execute step 140. |
| Step 140 : | determine whether the temperature of the network system is greater than a maximum operating temperature T_{MAX} longer than a first period; if yes, execute step 150; if no, execute step 110. |
| Step 150 : | log messages associated with an occurring over-temperature error on the network system and notify the remote server of the over-temperature error; execute step 160. |
| Step 160 : | operate the network system in a light-load mode; execute step 170. |
| Step 170 : | determine whether the network system has been operating in the light-load mode longer than a second period; if yes, execute step 200; if no, execute step 170. |
| Step 200 : | determine whether a restart command can be received; if yes, execute step 210; if no, execute step 200. |
| Step 210 : | restart the network system; execute step 110 |

In the present invention, the network system may be a network switch for OT applications, but is not limited thereto. As well-known to those skilled in the art, the temperature tolerance range for an electronic device refers to a range of the body temperature at which the electronic device is designed to operate for extended periods of time with acceptable stability of its electrical characteristics. Typically, the temperature tolerance range for industrial-grade equipment expands 2-3 times wider than the temperature range for standard commercial-grade equipment of the same type.

For illustrative purpose, it is assumed that the temperature tolerance range for the present network system is defined by a maximum operating temperature T_{MAX} and a minimum operating temperature T_{MIN}, and that the alert temperature T_{ALERT} is set to be smaller than the maximum operating temperature T_{MAX} and larger than the minimum operating temperature T_{MIN} of the network system. In an embodiment, the alert temperature T_{ALERT} is set in a way so that (T_{MAX}-T_{ALERT}) is smaller than (T_{ALERT}-T_{MIN}). This way, when the current temperature of the network system reaches the alert temperature T_{ALERT}, it is indicative of a smaller temperature margin before the network system encounters an over-temperature error. That is, any increase in temperate is more likely to cause an over-temperature error.

In step 110, the network system is configured to operate in the normal mode with its temperature being monitored on a real-time basis. In step 120, it is determined whether the temperature of the network system during normal-mode operation is greater than the alert temperature T_{ALERT}. If the temperature of the network system during normal-mode operation is greater than the alert temperature T_{ALERT}, it indicates that the network system is more likely to encounter an over-temperature error. Under such circumstance, step 130 is executed for logging messages associated with the possible imminent over-temperature error on the network system and for notifying the remote server of the possible imminent over-temperature error.

In step 140, it is determined whether the temperature of the network system is greater than the maximum operating temperature T_{MAX} longer than the first period after reaching the alert temperature T_{ALERT}. If the temperature of the network system during normal-mode operation continues to rise after reaching the alert temperature T_{ALERT} and remains greater than the maximum operating temperature longer than the first period, it indicates that the network system can no longer operate for extended periods of time with acceptable stability of its electrical characteristics. Under such circumstance, step 150 is executed for logging messages associated with the occurring over-temperature error on the network system and for notifying the remote server of the occurring over-temperature error.

In steps 130 and 150, the present invention can provide central monitoring and log collection. Logs from network devices provide important event and performance data. The messages logged on the network system and sent to the remote server in steps 130 and 150 may be collected, analyzed, and correlated for preventive measures as well as incidence response. Also, the remote server may monitor the operational status of the network system based on the notification message without logging into the network system directly.

As well-known to those skilled in the art, an application, a system or even a simple device is made up of several components, each of which performs specific functions to the best of its ability, while leaving other tasks to other components which are dedicated to taking care of them. For example, in the present network system, hardware and software components work together to analyze and forward traffic according to the configuration applied by the administrator. There are 3 planes defined in the networking infrastructure world: data plane, control plane, and management plane.

The data plane is a part of the network architecture where user packets are forwarded. It represents a set of forwarding resources that control plane policies operate on and enables the transfer of packets to and from end-users. The control plane is a part of the network architecture where the routing information and the processes responsible for running network protocols are located. The management plane is a part of the network architecture which allows administrative access to the device, analysis of its state and health and its reconfiguration. When the administrator is changing the configuration, the management plane will communicate with the control plane and issue changes to appropriate control plane processes. The management plane may also host processes that monitor the state of the device itself, such as fan speed, power supply failures, and the status of components belonging to the other planes.

Managing a network infrastructure may be done in two ways: in-band management or out-of-band management (OOBM). In an embodiment, the present network system may be an in-band network, wherein the in-band management traffic uses the same data plane as used by data traffic on the network system. Under such circumstance, the present network system may notify the remote server of the possible imminent over-temperature error (step 130) or the occurring over-temperature error (step 150) using common communications protocols adopted by its data plane, such as Telnet/SSH or SNMP, but not limited thereto. However, the method of managing the network infrastructure in the present network system does not limit the scope of the present invention.

In another embodiment, the present network system may be an OOBM network system, wherein OOB management takes place on a dedicated channel and is separated from data traffic. Generally speaking, OOBM is a more secure and resilient approach to managing a network infrastructure as it can function even during data traffic congestion, a device glitch or network attacks. In an OOBM network system, the administrator can monitor and manage each device via a dedicated management port. Under such circumstance, the present network system may notify the remote server of the possible imminent over-temperature error (step 130) or the occurring over-temperature error (step 150) via a dedicated management port. However, the method of managing the network infrastructure in the present network system does not limit the scope of the present invention.

In step 160, the network system switches to operate in the light-load mode after encountering an over-temperature error. In an embodiment, the network system may be completely shut down in the light-load mode. In another embodiment, the network system may disable all in-band interfaces for shutting down all data traffic in the light-load mode, thereby reducing its loading and waste heat. In yet another embodiment, the network system may disable all in-band ports for shutting down all data traffic in the light-load mode while keeping at least one OOB port or one 'console port enabled for receiving possible user commands, thereby reducing its loading and waste heat.

If it is determined in step 170 that the network system has been operating in the light-load mode longer than the second period, it is likely that the temperature of the network system has been lowered to a value within its temperature tolerance range. Under such circumstance, step 200 is executed for determining whether a restart command can be received from the remote server via a dedicated management port, an enabled OOB port or an enabled console port. If the administrator issues the restart command via the dedicated management port, the enabled OOB port or the enabled console port, or a pre-configured restart command has been initiated at the expiration of a pre-set clock, step 210 is then executed for restarting the network system and the present method loops back to step 110 for resuming normal mode operation and real-time temperate monitoring of the network system.

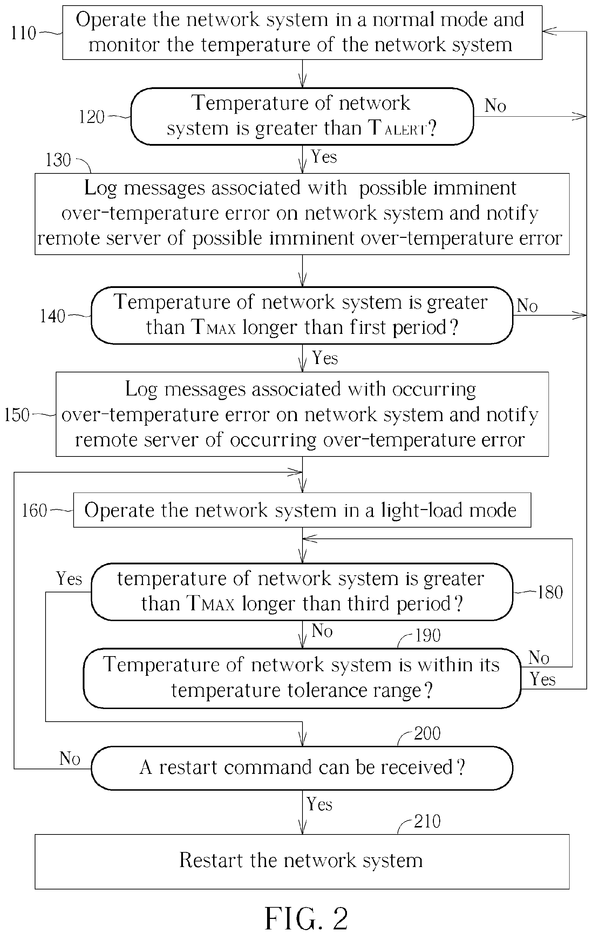

FIG. 2 is a flowchart illustrating a method of predicting over-temperature events, providing over-temperature countermeasures and providing system recovery in a network system according to another embodiment of the present invention. The flowchart in FIG. 2 includes the following steps:

| | |
|---|---|
| Step 110 : | operate the network system in a normal mode and monitor the temperature of the network system during operation. |
| Step 120: | determine whether the temperature of the network system is greater than an alert temperature T_{ALERT}; if yes, execute step 130; if no, execute step 110. |
| Step 130 : | log messages associated with a possible imminent over-temperature error on the network system and notify a remote server of the possible imminent over-temperature error; execute step 140. |
| Step 140 : | determine whether the temperature of the network system is greater than a maximum operating temperature T_{MAX} longer than a first period; if yes, execute step 150; if no, execute step 110. |
| Step 150 : | log messages associated with an occurring over-temperature error on the network system and notify the remote server of the over-temperature error; execute step 160. |
| Step 160 : | operate the network system in a light-load mode; execute step 180. |
| Step 180 : | determine whether the temperature of the network system is greater than the maximum operating temperature T_{MAX} longer than a third period; if yes, execute step 200; if no, execute step 190. |
| Step 190 : | determine whether the temperature of the network system is within its temperature tolerance range; if yes, execute step 110; if no, execute step 180. |
| Step 200 : | determine whether a restart command can be received; if yes, execute step 210; if no, execute step 160. |
| Step 210 : | restart the network system; execute step 110. |

The method depicted in FIG. 2 differs from the method depicted in FIG. 1 in that the flowchart of FIG. 2 includes steps 180 and 190 instead of step 170. After the network system switches to operate in the light-load mode in response to the over-temperature error in step 160, steps 180 and 190 are then executed for determining whether operating the network system in the light-load mode can overcome the over-temperature issue.

If it is determined in step 180 that the temperature of the network system is no longer greater than the maximum operating temperature T_{MAX} longer than the third period, step 190 is executed for determining whether the temperature of the network system is within its temperature tolerance range. If it is determined in step 190 that the temperature of the network system has resumed a normal temperature within its temperature tolerance range, it indicates that operating the network system in the light-load mode has overcome the over-temperature issue. Under such circumstance, the present method loops back to step 110 for resuming normal mode operation and real-time temperature monitoring of the network system.

If it is determined in step 180 that the temperature of the network system is greater than the maximum operating temperature T_{MAX} longer than the third period, it indicates that operating the network system in the light-load mode has not overcome the over-temperature issue. Under such circumstance, step 200 is then executed for determining whether a restart command can be received from the remote server via a dedicated management port, an enabled OOB port or an enabled console port, or a pre-configured restart command has been initiated at the expiration of a pre-set clock. If the administrator issues the restart command via the dedicated management port, the enabled OOB port or the enabled console port, or a pre-configured restart command has been initiated at the expiration of a pre-set clock, step 210 is then executed for restarting the network system and the present method loops back to step 110 for resuming normal mode operation and real-time temperature monitoring of the network system.

In conclusion, the present invention provides a two-step temperature notification scheme (the alert temperature T_{ALERT} associated with a possible imminent over-temperature error and the maximum operating temperature T_{MAX} associated with an occurring over-temperature error) in a network system. In response to an occurring over-temperature error detected during the normal operation, the network system is instructed to switch to operate in the light-load mode for reducing its loading by completely shutting down the network system or disabling all in-band interfaces for shutting down all data traffic, thereby attempting to overcome the over-temperature issue. Meanwhile, the present invention further provides an automatic system recovery scheme. When it is determined based on the temperature of the network system that the over-temperature issue has been overcome, when it is determined based on the operation time of the network system in the light-load mode that the over-temperature issue may have been overcome, or a restart command issued by the administrator via a remote server has been received, the network system is instructed to switch back to operate in the normal mode. Therefore, the present invention can provide a method of predicting over-temperature events, providing over-temperature countermeasures and providing system recovery in a network system.

## Claims

1. A method of performing over-temperature control in a network system, comprising:
operating the network system in a normal mode and monitoring a temperature of the network system during operation;
**characterized by** comprising:
notifying a remote server of a possible imminent over-temperature error when determining that the temperature of the network system is greater than an alert temperature; and
notifying the remote server of an occurring over-temperature error and operating the network system in a light-load mode when determining that the temperature of the network system is greater than a maximum operating temperature longer than a first period, wherein:
the network system generates less heat when operating in the light-load mode than in the normal mode;
the network system is unable to function normally when the temperature of the network system is greater than the maximum operating temperature; and
the alert temperature is not higher than the maximum operating temperature.

2. The method of claim 1, **further characterized by** comprising:
logging messages associated with the possible imminent over-temperature error on the network system when determining that the temperature of the network system is greater than the alert temperature; and
logging messages associated with the occurring over-temperature error on the network system when determining that the temperature of the network system is greater than the maximum operating temperature longer than the first period.

3. The method of any of claims 1-2, **characterized in that**:
the network system is completely shut down in the light-load mode.

4. The method of any of claims 1-2, **characterized in that**: the network system is configured to disable all in-band interfaces in the light-load mode for shutting down all data traffic.

5. The method of any of claims 1-4, **further characterized by** comprising:
determining whether a restart command can be received when it is determined that the network system has been operating in the light-load mode longer than a second period in response to the occurring over-temperature error; and
restarting the network system so as to resuming operating in the normal mode when it is determined that the restart command can be received.

6. The method of any of claim 5, **characterized in that**:
the network system is configured to disable all in-band interfaces in the light-load mode for shutting down all data traffic but keep at least one out-of-band port or a console port activated in the light-load mode for receiving the restart command.

7. The method of any of claims 5, **further characterized by** comprising:
determining whether the network system can receive the restart command via a dedicated management port, an out-of-band port or a console port.

8. The method of any of claims 1-4, **further characterized by** comprising:
determining whether the temperature of the network system is greater than the maximum operating temperature longer than a third period after the network system switches to operate in the light-load mode in response to the occurring over-temperature error;
determining whether the temperature of the network system is within a temperature tolerance range when it is determined that the temperature of the network system is not greater than the maximum operating temperature longer than the third period in the light-load mode; and
resuming operating the network system in the normal mode when it is determined that the temperature of the network system is within the temperature tolerance range, wherein:
the network system is able to function normally when the temperature of the network system is within the temperature tolerance range;
an upper limit of the temperature tolerance range is the maximum operating temperature;
a lower limit of the temperature tolerance range is a minimum operating temperature; and
the alarm temperature is not lower than the minimum operating temperature.

9. The method of any of claims 1-4, **further characterized by** comprising:
determining whether the temperature of the network system is greater than
the maximum operating temperature longer than a third period after the network system switches to operate in the light-load mode in response to the occurring over-temperature error;
determining whether a restart command can be received when it is
determined that the temperature of the network system is greater than the maximum operating temperature longer than the third period in the light-load mode; and
restarting the network system so as to resuming operating in the normal mode when it is determined that the restart command can be received.

10. The method of claim 9, **characterized in that**:
the network system is configured to disable all in-band interfaces in the light-load mode for shutting down all data traffic, but keep at least one out-of-band port or a control console port activated in the light-load mode for receiving the restart command.

11. The method of any of claims 9, **further characterized by** comprising:
determining whether the network system can receive the restart command via a dedicated management port, an out-of-band port or a console port.

12. The method of claim 1, **characterized in that**:
the network system is configured to notify the remote server of the possible imminent over-temperature error or the occurring over-temperature error using a common communication protocol adopted by a data plane.

13. The method of claim 1, **characterized in that**:
the network system is configured to notify the remote server of the possible imminent over-temperature error or the occurring over-temperature error using a dedicated management port.
